Europäisches Patentamt

European Patent Office

Office européen des brevets

(11) Publication number: **0 086 090**
**B1**

(12) **EUROPEAN PATENT SPECIFICATION**

(45) Date of publication of patent specification: **30.07.86**

(21) Application number: **83300557.2**

(22) Date of filing: **03.02.83**

(51) Int. Cl.⁴: **H 03 K 5/02,** H 03 K 19/003,
H 03 K 19/017, G 11 C 8/00,
G 11 C 7/02

(54) **Drive circuit for capacitive loads.**

(30) Priority: **03.02.82 JP 16122/82**

(43) Date of publication of application:
**17.08.83 Bulletin 83/33**

(45) Publication of the grant of the patent:
**30.07.86 Bulletin 86/31**

(84) Designated Contracting States:
**DE FR GB**

(56) References cited:

**E.R. HNATEK "User's guidebook to digital
CMOS integrated circuits" 1981, McGRAW-HILL
BOOK CO., New York pages 18-33**

(73) Proprietor: **NEC CORPORATION
33-1, Shiba 5-chome, Minato-ku
Tokyo 108 (JP)**

(72) Inventor: **Nakaizumi, Kazuo Nippon Electric Co.,
Limited
33-1 Shiba Gochome Minato-ku
Tokyo (JP)**

(74) Representative: **Smith, Philip Antony et al
REDDIE & GROSE 16 Theobalds Road
London WC1X 8PL (GB)**

## Description

The present invention relates to a drive circuit for driving a capacitive load to charge and discharge the load, comprising an output stage having an output terminal to which a capacitive load may be coupled. The invention relates particularly, though not exclusively, to inverter circuits making use of complementary insulated gate field effect transistors (hereinafter abbreviated as CMOSFET's). More particularly, it relates to an inverter circuit with a capacitive load connected to the output terminal thereof in which a heavy transient current would flow from a power supply under a transient condition where an input signal is changed to invert the inverter output.

Since an inverter circuit using CMOSFET's (hereinafter abbreviated as CMOS inverter) consumes almost no electrical power under static conditions, it is suitable for large-scale integrated circuits (hereinafter abbeviated as IC). Under the transient conditions, however, a considerable power supply current (hereinafter abbreviated as $I_{DD}$) flows through the CMOS inverter due to the charging current flowing into the capacitive component of the load. Accordingly, the peak value of $I_{DD}$ in the CMOS inverter is large during the transient period, as described on page 23 and shown in Fig. 2—6 of "User's Guidebook to Digital CMOS Integrated Circuits", by E. R. Hnatek, McGraw-Hill Book Co., New York 1981. Therefore, it is necessary to take measures such as lowering of the impedance of the power supply wiring to the CMOS inverter, but such a measure would detract from the merit of the CMOS circuit that it can use fine wiring because of its low power consumption. This problem becomes more acute in a memory IC where a large number of address inverters operate simultaneously. For instance, in a 64 K-bit memory, an address input is 16-bit, which means that at least 16 address inverters operate simultaneously in response to 16 address input signals applied in parallel. In that case, $I_{DD}$ is multiplied by a factor of 16, and an extremely large peak current flows from the power supply of this memory IC. Consequently, noise is generated in power supply lines, causing many faults in the operation of the memory IC.

It has been proposed to reduce the peak current by prolonging the switching time of the CMOS inverter, that is, by gradually charging the load capacitance. However, this method has a drawback that speed-up of the whole IC is prevented because of a prolonged response time of the inverter.

It is an object of the present invention to provide a circuit in which a peak value of a load capacitance charging current component in the power supply current can be largely reduced with a high-speed operation. Accordingly, the invention is characterised by an auxiliary circuit which comprises a capacitor, first means coupled between the capacitor and a power supply terminal and operable to charge the capacitor before the output stage charges a capacitive load coupled to the output terminal, and second means coupled between the capacitor and the output terminal and operable to charge a capacitive load connected to the output terminal by a discharge current from the capacitor while the output stage is charging the load.

According to a preferred embodiment of the present invention, there is provided an inverter circuit responsive to an input signal for outputting an inverted signal of the input signal, with a first auxiliary circuit connected to the inverter circuit. The first auxiliary circuit includes an auxiliary capacitor which is charged at a time other than the transient time when the output transfers from the low level to the high level (e.g. when the input signal is "1" (or "0") level), and discharged as a part of an output current of the inverter circuit during the transient period when the input signal is changed from the low level to the high level. Since discharge current from the capacitor is added to the power supply current from the power supply for charging the capacitive load in the transient period, the peak power supply current in the transient period can be greatly reduced. The power supply current for charging the auxiliary capacitor flows at a time other than the transient period and contributes to reduce the peak current.

In a preferred arrangement, the drive circuit further comprises third means coupled between the power supply terminal and the output terminal and operable to charge a capacitive load connected to the output terminal by a current from the power supply after the discharge current from the capacitor starts to flow.

The output stage preferably includes a first P-channel type field effect transistor (hereinafter abbreviated as Pch-FET) and a first N-channel type field effect transistor (hereinafter abbreviated as Nch-FET) connected in series and inserted between the power supply terminal and a ground terminal, the gates of the two transistors being connected in common to form an input terminal, the common junction point of the two transistors being coupled to the output terminal, the first means including a second P-channel type field effect transistor having its gate connected to the ground terminal, the second means including third and fourth P-channel type field effect transistors connected in series with each other and having their gates connected respectively to the output terminal and the input terminal, the capacitor being connected between the common junction point of the second and third P-channel type field effect transistors and the ground terminal, and preferably comprises a second auxiliary circuit including a fifth P-channel type field effect transistor connected between the power supply terminal and the ground terminal and having its gate connected via a delay circuit 14 to the input terminal. The second auxiliary circuit may further include a sixth Pch-FET inserted between the fifth FET and the output terminal and having its gate connected to the input terminal. With the first and second auxiliary circuits, the inverter circuit according to this invention can reduce the peak value of the capacitive load charging current component in the power supply current as compared to the prior art circuit, while maintaining a high-speed operation.

The invention will now be described in more detail, by way of example with reference to the accompanying drawings, in which:

Fig. 1 is a circuit diagram of a basic inverter circuit in the prior art making use of CMOSFET's.

Fig. 2 is an operation waveform diagram showing an input signal $\phi_{IN}$, and output signal $\phi_{OUT}$, and a charging current component $I_{DDL}$ for a load capacitor $C_L$ in a power supply current $I_{DD}$ as functions of time in the inverter circuit shown in Fig. 1.

Fig. 3 is a circuit diagram showing one preferred embodiment of the present invention.

Fig. 4 is an operation waveform diagram showing signal voltages as well as a load capacitor charging current component in a power supply current when the input signal in the circuit shown in Fig. 3 is turned from "1" level to "0" level.

Fig. 5 is an operation waveform diagram showing signal voltages as well as a load capacitor charging current component in a power supply current when the input signal in the circuits shown in Figs. 3 and 6 is changed from "0" level to "1" level.

Fig. 6 is a circuit diagram showing another preferred embodiment of the present invention.

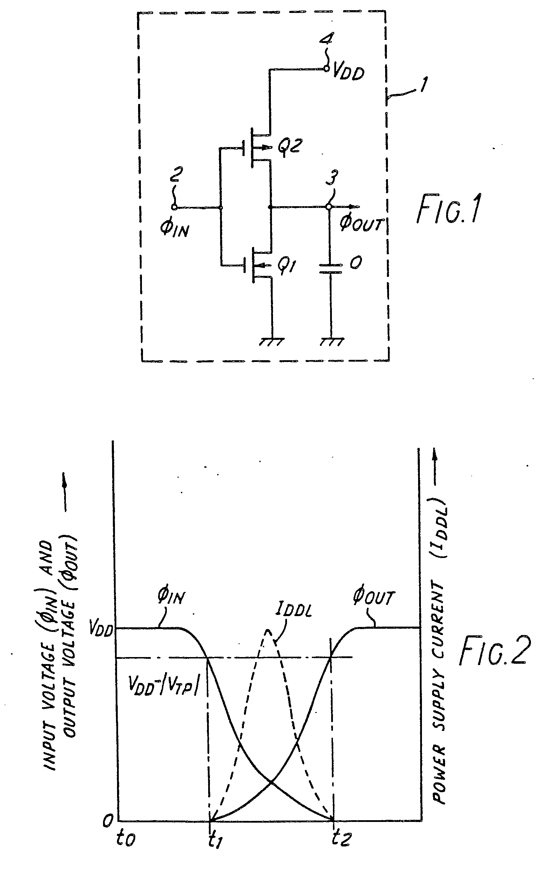

Referring to Fig. 1, a prior art inverter circuit comprises an Nch-FET $Q_1$ and a Pch-FET $Q_2$ with their drains connected in common to form an output terminal 3. The source of the FET $Q_1$ is connected to a $V_{SS}$ power supply terminal (in the illustrated example, to the ground terminal) and the source of the FET $Q_2$ is connected to a $V_{DD}$ power supply terminal 4 (in the illustrated example, $V_{DD}$ represents a positive voltage). The gates of the both FET's are connected in common and form an input terminal 2. It is to be noted that a capacitive load, shown as capacitor $C_L$, is present between the output terminal 3 and the ground terminal.

Referring also to Fig. 2, when the input signal $\phi_{IN}$ is at "1" level (in the illustrated example, a high voltage $V_{DD}$ level) at a time $t_0$, the Nch-FET $Q_1$ is ON, and hence the output signal $\phi_{OUT}$ maintains "0" level ($V_{SS}$ level). Since the Pch-FET $Q_2$ is OFF at this time, the power supply current $I_{DD}$ does not flow. Subsequently, the input signal $\phi_{IN}$ begins to transfer from "1" level to "0" level (in the illustrated example a low voltage ($V_{SS}$, 0 volt level), and when the voltage of the input signal has lowered to $V_{DD}-V_{TP}$ ($V_{TP}$: a threshold voltage of the Pch-FET $Q_2$) at a time $t_1$, the Pch-FET $Q_2$ is turned ON and a power supply current $I_{DD}$ begins to flow. As a result, the voltage of the output signal $\phi_{OUT}$ begins to rise, determined by the capability ratio between the Nch-FET $Q_1$ and the Pch-FET $Q_2$. As the voltage of the output signal $\phi_{OUT}$ rises, the load capacitor $C_L$ is driven, and a

charging current $I_{DDL}$ flows from the $V_{DD}$ power supply terminal through the Pch-FET $Q_2$ into the load capacitor $C_L$. Therefore, the power supply current $I_{DD}$ which is the sum of the charging current $I_{DDL}$ and a current $I_{DDO}$ flowing through the FET $Q_1$ to the ground becomes large. Then, the input signal $\phi_{IN}$ approaches "0" level, and when the voltage reaches $V_{TN}$ (a threshold voltage of the Nch-FET $Q_1$), the Nch-FET $Q_1$ is turned OFF, and the power supply current component flowing through the Nch-FET $Q_1$ ($I_{DDO}$) ceases to flow. When the input signal $\phi_{IN}$ reaches "0" level at a time $t_2$, the output signal $\phi_{OUT}$ also reaches "1" level, so that the $I_{DDL}$ also ceases to flow. Thus the charging current component $I_{DDL}$ has a nearly symmetric waveform with a large peak value. The peak value of the charging current $I_{DDL}$ would become larger as the load capacitor $C_L$ is increased. As described previously, to reduce the peak value of this $I_{DDL}$ is an important problem to be solved.

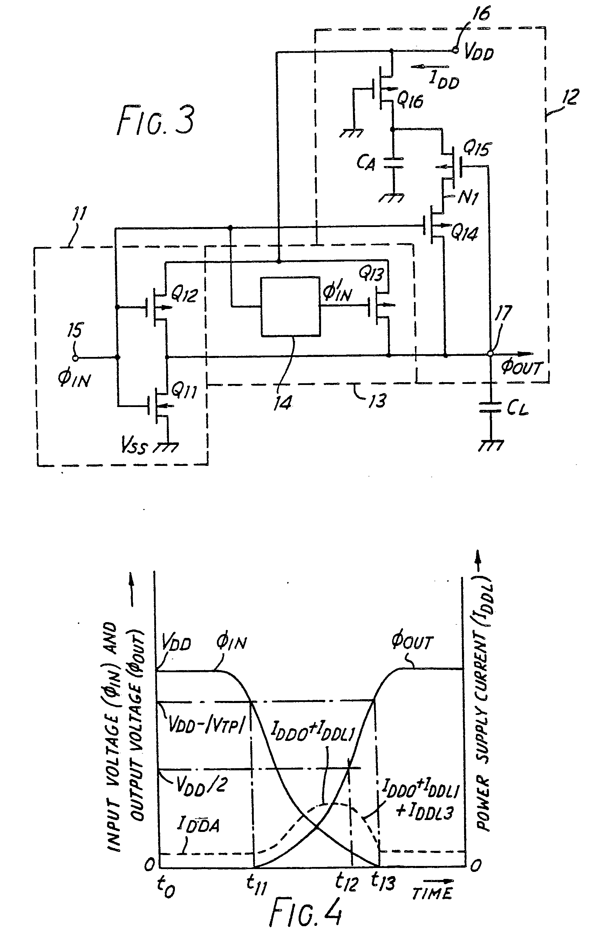

With reference to Fig. 3, the circuit of a preferred embodiment of the present invention comprises a basic inverter circuit 11 which includes a first Pch-FET $Q_{12}$ and a first Nch-FET $Q_{11}$ connected in series at an output terminal 17. The source of the Nch-FET $Q_{11}$ is connected to $V_{SS}$ terminal (the ground terminal in this example) and the source of the Pch-FET $Q_2$ is connected to a $V_{DD}$ power supply terminal 16. The gates of the Nch-FET $Q_{11}$ and the Pch-FET $Q_{12}$ are both connected to an input terminal 5. A first auxiliary circuit 12 is added to the inverter circuit 11, which in turn includes second, third and fourth Pch-FET's $Q_{14}$, $Q_{15}$ and $Q_{16}$ connected in series between the $V_{DD}$ power supply terminal 16 and the output terminal 17. The respective gates of $Q_{14}$, $Q_{15}$ and $Q_{16}$ are connected to the input terminal 15, the output terminal 17, and the ground terminal, respectively. The first auxiliary circuit further includes an auxiliary capacitor $C_A$ inserted between the common junction point of the Pch-FET's $Q_{15}$ and $Q_{16}$ and the ground terminal. A secondary auxiliary circuit 13 is also added, which includes a fifth Pch-FET $Q_{13}$ inserted between the $V_{DD}$ power supply terminal 16 and the output terminal 17 and a delay circuit 14 inserted between the input terminal 15 and the gate of $Q_{13}$. The delay circuit 14 is used to delay the input signal $\phi_{IN}$ by a predetermined period. Since its precision is not critical, the delay circuit 14 can be easily constructed as per the known technique.

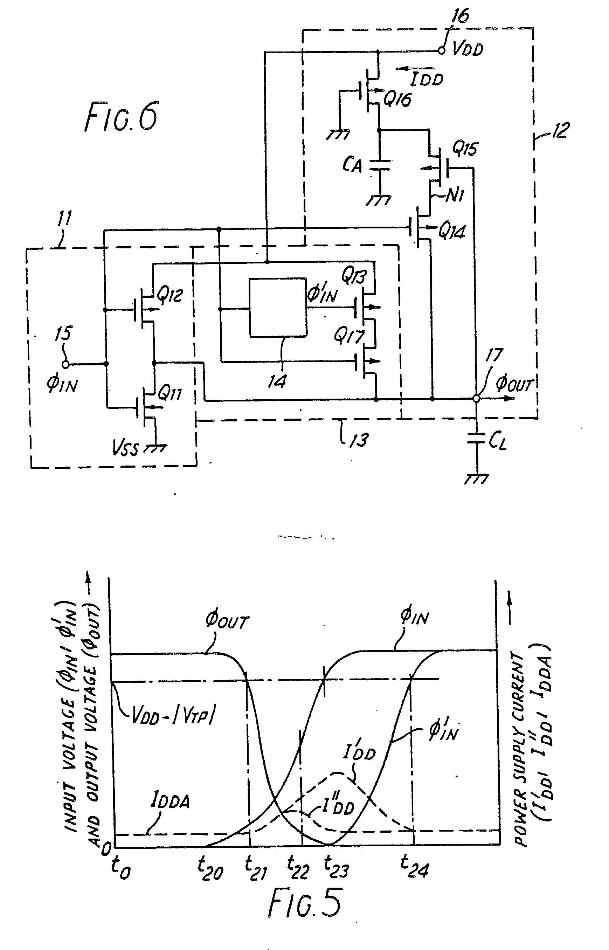

Now a description will be given of the operation of this circuit when the input signal $\phi_{IN}$ transfers from "1" level ($V_{DD}$) to "0" level (ground), with reference to Fig. 4. Since the basic inverter circuit 11 has the same construction as the circuit in the prior art shown in Fig. 1, its operation is also basically quite the same.

At first, when the input signal $\phi_{IN}$ is at "1" level ($V_{DD}$) at a time between $t_0$ and $t_{11}$, the Pch-FET's $Q_{15}$ and $Q_{16}$ of the first auxiliary circuit 12 are ON and the Pch-FET $Q_{14}$ is OFF. Hence the auxiliary capacitor $C_A$ is charged via the Pch-FET $Q_{16}$ by $V_{DD}$

and stores electric charge therein. Accordingly, the charging current $I_{DDA}$ for this capacitor $C_A$ flows from the $V_{DD}$ power supply terminal 16 as a component of the power supply current $I_{DD}$, at the period of $t_0$ to $t_{11}$. At this moment, the Nch-FET $Q_{11}$ is ON and the Pch-FET's $Q_{12}$ and $Q_{13}$ are OFF. Therefore, the output voltage $\phi_{OUT}$ at the output terminal 17 is "0" level, and the power supply current $I_{DD0}$ through the Nch-FET $Q_{11}$ and the charging current $I_{DDL}$ for the load capacitor $C_L$ are both zero.

Within the period from $t_0$ to $t_{11}$, the input signal $\phi_{IN}$ starts to fall. When the voltage of the input signal $\phi_{IN}$ is lowered to $V_{DD}-V_{TP}$ at the time $t_{11}$, then the Pch-FET $Q_{12}$ and the Pch-FET $Q_{14}$ are turned ON, and hence a current $I_{DD0}$ through the Pch-FET $Q_{12}$ and the Nch-FET $Q_{11}$ and a charging current $I_{DDL1}$ through the Pch-FET $Q_{12}$ for charging the load capacitor $C_L$ begin to flow, which are components of the power supply current $I_{DD}$. Furthermore, the electric charge previously stored in the auxiliary capacitor $C_A$ begins to discharge as a part of the charging current for the load capacitor $C_L$ through the Pch-FET $Q_{14}$ (this component being represented by $I_{DDL2}$). Since this discharge current $I_{DDL2}$ is based on discharge of electric charge that has been preliminarily stored in the auxiliary element $C_A$, an increment of the power supply current $I_{DD}$ that is necessary for $I_{DDL2}$ after the time $t_{11}$ is very small. If the capability of the Pch-FET $Q_{16}$ is chosen less than about 1/10 of that of the Pch-FET $Q_{12}$, then the $I_{DD}$ component passing through the Pch-FET $Q_{16}$ is limited, and therefore the mentioned increment can be approximately neglected. Moreover, if the auxiliary capacitor $C_A$ is chosen nearly of the same capacitance as the load capacitor $C_L$, then about one-half of the charging current $I_{DDL}$ can be shared by the $I_{DDL2}$.

Subsequently, the voltage of the input signal $\phi_{IN}$ is further lowered after $t_{11}$ and accordingly the voltage of the output signal $\phi_{OUT}$ rises, and when the output voltage value reaches about $V_{DD}/2$ at a time $t_{12}$, the input signal $\phi_{IN}'$ delayed by the delay circuit 14 in the secondary auxiliary circuit is applied to the Pch-FET $Q_{13}$, so that the Pch-FET $Q_{13}$ is turned ON and sends out an output current to the output terminal 17 which forms another part of the charging current for the load capacitor $C_L$ (this component being called $I_{DDL3}$). As a result the power supply current $I_{DD}$ is added with the $I_{DDL3}$ component. On the other hand, the potential at a node $N_2$ which serves as one terminal of the auxiliary capacitor $C_A$ becomes nearly the same level as the $\phi_{OUT}$ when the voltage of the output signal $\phi_{OUT}$ exceeds $V_{DD}/2$, and hence the Pch-FET $Q_{15}$ is turned OFF, so that the charging current $I_{DDL2}$ from the auxiliary capacitor $C_A$ is eliminated. Therefore, in this case the charging current for the load capacitor $C_L$ could be constituted of two components, that is, the $I_{DDL1}$ passing through the Pch-FET $Q_{12}$ and the $I_{DDL3}$ passing through the Pch-FET $Q_{13}$. This $I_{DDL3}$ component compensates for the above-described $I_{DDL2}$ component to promote charging of the load capacitor $C_L$ and serves to quickly raise the voltage of the output signal $\phi_{OUT}$. Therefore, it is favourable to select the capability of the Pch-FET $Q_{13}$ larger than that of the Pch-FET $Q_{12}$.

Next, when the input signal $\phi_{IN}$ approaches "0" level and its voltage becomes equal to or lower than $V_{TN}$, then the Nch-FET $Q_{11}$ is turned OFF, and hence the $I_{DD0}$ component passing through the Nch-FET ceases to flow. Then, the input signal $\phi_{IN}$ reaches "0" level and the output signal $\phi_{OUT}$ reaches "1" level at a time $t_{13}$, and as a result, the $I_{DDL1}$ component passing through the Pch-FET $Q_{12}$ as well as the $I_{DDL3}$ component passing through the Pch-FET $Q_{13}$ are also eliminated.

As will be apparent from the above description, in the circuit of the illustrated embodiment, the charging current $I_{DDL}$ for the load capacitor $C_L$ is formed in such manner that until the voltage of the output signal $\phi_{OUT}$ becomes nearly equal to $V_{DD}/2$, the charging current is occupied by the $I_{DDL1}$ passing through the Pch-FET $Q_{12}$ and the discharging current $I_{DDL2}$ of the auxiliary capacitor $C_A$ which has been preliminarily charged, and after the output signal $\phi_{OUT}$ nearly exceeds $V_{DD}/2$, the $I_{DDL2}$ is eliminated and instead the $I_{DDL3}$ passing through the Pch-FET $Q_{13}$ is newly added. Consequently, the load capacitor charging current component $I_{DDL}$ in the power supply current of the circuit would flow over the entire region of operation, and its peak value during the period of $t_{11}$ to $t_{13}$ becomes very small as shown in Fig. 4. The extent of this reduction of the peak value depends upon the design of the first and second auxiliary circuits such as the magnitude of the auxiliary capacitor $C_A$ and the capability of the Pch-FET $Q_{13}$. However, it is quite easy to reduce to 1/2 or less of the peak value in the prior art.

Furthermore, since those auxiliary charging currents can be subjected to appropriate adjustment by varying the delay characteristics of the delay circuit 14 in the second auxiliary circuit 13 so as to meet the response time of the circuit, there is no need to prolong the response time of the inverter circuit 11, but the response time may be rather shortened by selecting appropriate timing.

Now description will be made of the case where the input signal transfers from "0" level to "1" level, with reference to Fig. 5 which shows waveforms of the input signal $\phi_{IN}$, the output signal $\phi_{OUT}$ and the power supply current $I_{DD}$ in this case.

At first, during the period of $t_0$ to $t_{20}$ when the input signal $\phi_{IN}$ is at "0" level (ground), the Pch-FET's $Q_{12}$, $Q_{13}$, $Q_{14}$ and $Q_{16}$ are ON and the Nch-FET $Q_{11}$ and the Pch-FET $Q_{15}$ are OFF. Accordingly, the auxiliary capacitor $C_A$ is charged, and a power supply current necessitated by the charging current $I_{DDA}$ flows.

Next, the input signal $\phi_{IN}$ starts to rise at a time $t_{20}$. When it rises up to $V_{TN}$ at a time $t_{21}$, the Nch-FET $Q_{11}$ is turned ON and the discharge current of the load capacitor $C_L$ begins to flow through the Nch-FET $Q_{11}$. Furthermore the power supply current $I_{DD0}$ flows through the Pch-FET $Q_{12}$

and the Nch-FET $Q_{11}$, and the power supply current $I_{DDO}'$ flows through the Pch-FET $Q_{13}$ and the Nch-FET $Q_{11}$. At this moment, since the Pch-FET $Q_{15}$ is kept OFF, only the $I_{DDA}$ flows through the first auxiliary circuit.

Subsequently, when the input signal $\phi_{IN}$ reaches $V_{DD}-V_{TP}$, at a time $t_{23}$, the Pch-FET $Q_{12}$ is turned OFF and $I_{DDO}$ ceases to flow, but since the voltage of the delayed signal $\phi_{IN}'$ for the input signal $\phi_{IN}$ which is a driving voltage for the Pch-FET $Q_{13}$ does not rise as shown in Fig. 5, the Pch-FET $Q_{13}$ is still kept ON, and so $I_{DDO}'$ continues to flow. Thereafter when the $\phi'_{IN}$ becomes $V_{DD}-V_{TP}$ at a time $t_{24}$, the Pch-FET $Q_{13}$ is turned OFF and $I_{DDO}'$ ceases to flow. The input signal $\phi_{IN}$ reaches "1" level, and the output signal $\phi_{OUT}$ reaches "0" level.

In other words, in the transient period when the input signal $\phi_{IN}$ transfers from "0" level to "1" level, the $I_{DDO}'$ passing through the Pch-FET $Q_{13}$ is added to the power supply current $I_{DDO}$ which flows together with the discharge current of the load capacitor $C_L$ in the circuit known in the prior art, and therefore, the overall power supply current $I_{DD}'$ takes the form shown in Fig. 5. As described, the circuit of the illustrated embodiment of Fig. 3 involves a problem that although the peak value of the load capacitor charging current component $I_{DDL}$ in the power supply current $I_{DD}$ can be greatly reduced when the input signal $\phi_{IN}$ transfers from "1" level to "0" level, the power supply current $I_{DDO}'$ caused by the second auxiliary circuit is added to the power supply current when the input signal $\phi_{IN}$ transfers from "0" level to "1" level.

The circuit of another preferred embodiment of the present invention shown in Fig. 6 resolves the above-mentioned problem. The only difference from the circuit shown in Fig. 3 and described previously resides in that the second auxiliary circuit 13' includes another Pch-FET $Q_{17}$ inserted between the drain of the Pch-FET $Q_{13}$ and the output terminal 17 and having its gate connected to the input terminal 15. In this circuit of the modified embodiment, the Pch-FET $Q_{17}$ is turned OFF in response to the input signal $\phi_{IN}$ and the $I_{DDO}'$ also ceases to flow at the same time as $I_{DDO}$ does not flow through $Q_{12}$. Therefore, the $I_{DD}$ in this modified embodiment becomes small as indicated by $I_{DD}''$ in Fig. 5.

It is to be noted that in the above-described embodiments, the conductivity type of the respective FET's can be changed if necessary. For instance, in place of the Pch-FET and Nch-FET can be used for the FET $Q_{14}$, and an inverted input signal $\phi_{IN}$ then be applied to the gate of this FET. The Pch-FET's and Nch-FET's may be replaced by Nch-FET's and Pch-FET's, respectively, with the terminals of the power supply voltage being reversely connected.

**Claims**

1. A drive circuit for driving a capacitive load to charge and discharge the load, comprising an output stage (11) having an output terminal (17) to which a capacitive load ($C_L$) may be coupled, and characterised by an auxiliary circuit (12) which comprises a capacitor ($C_A$), first means ($Q_{16}$) coupled between the capacitor ($C_A$) and a power supply terminal (16) and operable to charge the capacitor ($C_A$) before the output stage (11) charges a capacitive load ($C_L$) coupled to the output terminal (17), and second means ($Q_{14}$, $Q_{15}$) coupled between the capacitor ($C_A$) and the output terminal (17) and operable to charge the capacitive load ($C_L$) connected to the output terminal (17) by a discharge current from the capacitor ($C_A$) while the output stage (11) is charging the load ($C_L$).

2. A drive circuit according to claim 1, characterised in that it further comprises third means (13) coupled between the power supply terminal (16) and the output terminal (17) and operable to charge the capacitive load ($C_L$) connected to the output terminal (17) by a current from the power supply after the discharge current from the capacitor ($C_A$) starts to flow.

3. A drive circuit according to claim 1 or 2, characterised in that the first means includes a first switch transistor ($Q_{16}$) and the second means includes second and third switch transistors ($Q_{15}$, $Q_{14}$) connected in series between the capacitor ($C_A$) and the output terminal (17), the second switch transistor ($Q_{15}$) being controlled by the voltage ($\phi_{OUT}$) at the output terminal (17), and the third switch transistor ($Q_{14}$) being controlled by an input signal ($\phi_{IN}$) supplied to the output stage.

4. A drive circuit according to claim 2 or 3, characterised in that the third means include a delay circuit (14) for delaying an input signal ($\phi_{IN}$) supplied to the output stage and a fourth switch transistor ($Q_{13}$) connected between the one terminal (16) of the power supply and the output terminal (17), and being controlled by the delayed input signal ($\phi_{IN}'$).

5. A drive circuit according to claim 1, characterised in that the output stage includes a first P-channel type field effect transistor ($Q_{12}$) and a first N-channel type field effect transistor ($Q_{11}$) connected in series and inserted between the power supply terminal (16) and a ground terminal, the gates of the two transistors being connected in common to form an input terminal (15), the common junction point of the two transistors being coupled to the output terminal (17), the first means including a second P-channel type field effect transistor ($Q_{16}$) having its gate connected to the ground terminal, the second means including third and fourth P-channel type field effect transistors ($Q_{15}$, $Q_{14}$) connected in series with each other and having their gates connected respectively to the output terminal and the input terminal, the capacitor ($C_A$) being connected between the common junction point of the second and third P-channel type field effect transistors ($Q_{16}$, $Q_{15}$) and the ground terminal, and further characterised by comprising a second auxiliary circuit including a fifth P-channel type field effect transistor ($Q_{13}$) connected between the

power supply terminal (16) and the output terminal (17) and having its gate connected via a delay circuit (14) to the input terminal (15).

6. A drive circuit according to claim 5, characterised in that the second auxiliary circuit includes a sixth P-channel type field effect transistor ($Q_{17}$) inserted between the fifth P-channel type field effect transistor ($Q_{13}$) and the output terminal (17) and having its gate connected to the input terminal (15).

**Patentansprüche**

1. Treiberschaltung zum Treiben einer kapazitiven Last zum Laden und Entladen der Last, mit einer Ausgangsstufe (11) mit einem Ausgangsanschluß (17), mit dem eine kapazitive Last ($C_L$) verbunden werden kann, und gekennzeichnet durch eine Hilfsschaltung (12) mit einem Kondensator ($C_A$), einer zwischen den Kondensator ($C_A$) und einen Netzanschluß (16) gekoppelten ersten Einrichtung ($Q_{16}$), die den Kondensator ($C_A$) lädt, bevor die Ausgangsstufe (11) eine mit dem Ausgangsanschluß (17) verbundene kapazitive Last ($C_L$) lädt, und mit einer zwischen den Kondensator ($C_A$) und den Ausgangsanschluß (17) gekoppelten zweiten Einrichtung ($Q_{14}$, $Q_{15}$), die die mit dem Ausgangsanschluß (17) verbundene kapazitive Last ($C_L$) durch einen Entladestrom vom Kondensator ($C_A$) lädt, während die Ausgangsstufe (11) die Last ($C_L$) lädt.

2. Treiberschaltung nach Anspruch 1, ferner gekennzeichnet durch eine zwischen den Netzanschluß (16) und den Ausgangsanschluß (17) gekoppelte dritte Einrichtung (13), die die mit dem Ausgangsanschluß (17) verbundene kapazitive Last ($C_L$) durch einen Strom vom Netzteil lädt, nachdem der Entladestrom vom Kondensator ($C_A$) zu fließen beginnt.

3. Treiberschaltung nach Anspruch 1 oder 2, dadurch gekennzeichnet, daß die erste Einrichtung einen ersten Schalttransistor ($Q_{16}$) und die zweite Einrichtung zweite und dritte Schalttransistoren ($Q_{15}$, $Q_{14}$) aufweisen, die in Reihe zwischen dem Kondensator ($C_A$) und dem Ausgangsanschluß (17) geschaltet sind, wobei der zweite Schalttransistor ($Q_{15}$) durch die Spannung ($\phi_{OUT}$) am Ausgangsanschluß (17) und der dritte Schalttransistor ($Q_{14}$) durch ein der Ausgangsstufe zugeführtes Eingangssignal ($\phi_{IN}$) gesteuert wird.

4. Treiberschaltung nach Anspruch 2 oder 3, dadurch gekennzeichnet, daß die dritte Einrichtung einen Verzögerungskreis (14) zum Verzögern eines der Ausgangsstufe zugeführten Eingangssignals ($\phi_{IN}$) und einen vierten Schalttransistor ($Q_{13}$) aufweist, der zwischen den einen Anschluß (16) des Netzteils und den Ausgangsanschluß (17) geschaltet ist und vom verzögerten Eingangssignal ($\phi'_{IN}$) gesteuert wird.

5. Treiberschaltung nach Anspruch 1, dadurch gekennzeichnet, daß die Ausgangsstufe einen ersten P-Kanal-Feldeffect-Transistor ($Q_{12}$) und einen ersten N-Kanal-Feldeffekt-Transistor ($Q_{11}$) aufweist, die in Reihe geschaltet und zwischen den Netzanschluß (16) und einen Erdanschluß eingefügt sind, wobei die Gatter der beiden Transistoren miteinander verbunden sind und einen Eingangsanschluß (15) bildet, wobei der gemeinsame Verbindungspunkt der beiden Transistoren mit dem Ausgangsanschluß (17) verbunden ist, die erste Einrichtung einen zweiten P-Kanal-Feldeffekttransistor ($Q_{16}$) aufweist, dessen Gatter mit dem Erdanschluß verbunden ist, die zweite Einrichtung einen dritten und einen vierten P-Kanal-Feldeffekttransistor ($Q_{15}$, $Q_{14}$) aufweist, die in Reihe miteinander verbunden sind und deren Gatter jeweils mit dem Ausgangsanschluß und dem Eingangsanschluß verbunden sind, der Kondensator ($C_A$) zwischen den gemeinsame Verbindungspunkt des zweiten und des dritten P-Kanal-Feldeffekttransistors ($Q_{16}$, $Q_{15}$) und den Erdanschluß geschaltet ist, und die Schaltung ferner gekennzeichnet ist durch einen zweiten Hilfsschaltkreis mit einem fünften P-Kanal-Feldeffekttransistor ($Q_{13}$), der zwischen den Netzanschluß (16) und den Ausgangsanschluß (17) geschaltet ist und dessen Gatter über einen Verzögerungskreis (14) mit dem Eingangsanschluß (15) verbunden ist.

6. Treiberschaltung nach Anspruch 5, dadurch gekennzeichnet, daß der zweite Hilfsschaltkreis einen sechsten P-Kanal-Feldeffekttransistor ($Q_{17}$) aufweist, der zwischen den fünften P-Kanal-Feldeffektransistor ($Q_{13}$) und den Ausgangsanschluß (17) eingefügt ist und dessen Gatter mit dem Eingangsanschluß (15) verbunden ist.

**Revendications**

1. Circuit de commande pour la commande d'une charge capacitive afin de charger et décharger la charge comprenant un étage de sortie (11) ayant une borne de sortie (17) à laquelle peut être reliée une charge capacitive ($C_L$), et caractérisé par un circuit auxiliaire (12) qui comprend un condensateur ($C_A$), un premier moyen ($Q_{16}$) monté entre le condensateur ($C_A$) et une borne d'alimentation (16) et pouvant fonctionner pour charger le condensateur ($C_A$) avant que l'étage de sortie (11) charge une charge capacitive ($C_L$) branchée à la borne de sortie (17), et un second moyen ($Q_{14}$, $Q_{15}$) monté entre le condensateur ($C_A$) et la borne de sortie (17) et pouvant fonctionner pour charger la charge capacitive ($C_L$) connectée à la borne de sortie (17) par un courant décharge provenant du condensateur ($C_A$) alors que l'étage de sortie (11) procède à la charge de la charge ($C_L$).

2. Circuit de commande selon la revendication 1, caractérisé en ce qu'il comprend en outre un troisième moyen (13) monté entre la borne d'alimentation (16) et la borne de sortie (17) et pouvant fonctionner pour charger la charge capacitive ($C_L$) connectée à la borne de sortie (17) par un courant provenant de l'alimentation après que le courant de décharge provenant de condensateur ($C_A$) mit commencé à circuler.

3. Circuit de commande selon la revendication 1 ou 2, caractérisé en ce que le premier moyen comprend un premier transistor de commutation ($Q_{16}$) et le second moyen comprend des second et troisième transistors de commutation ($Q_{15}$, $Q_{14}$) connectés en série entre le condensateur ($C_A$) et la borne de sortie (17), le second transistor de commutation ($Q_{15}$) étant commandé par la tension ($\phi_{OUT}$) à la borne de sortie (17), et le troisième transistor de commutation ($Q_{14}$) étant commandé par un signal d'entrée ($\phi_{IN}$) appliqué à l'étage de sortie.

4. Circuit de commande selon la revendication 2 ou 3, caractérisé en ce que le troisième moyen comprend un circuit à retard (14) pour retarder un signal d'entrée ($\phi_{IN}$) fourni à l'étage de sortie et un quatrième transistor de commutation ($Q_{13}$) connecté entre ladite borne (16) de l'alimentation et la borne de sortie (17), et étant commandé par le signal d'entrée retardé ($\phi'_{IN}$).

5. Circuit de commande selon la revendication 1, caractérisé en ce que l'étage de sortie comprend un premier transistor à effet de champ à canal P ($Q_{12}$) et un premier transistor à effet de champ à canal N ($Q_{11}$) connectés en série et insérés entre la borne (16) de l'alimentation et une borne de masse, les grilles des deux transistors étant connectées en commun de manière à former une borne d'entrée (15), le point de jonction commun des deux transistors étant relié à la borne de sortie (17), le premier moyen comportant un second transistor à effet de champ à canal P ($Q_{16}$) ayant sa grille connectée à la borne de masse, le second moyen comportant des troisième et quatrième transistors à effet de champ à canal P ($Q_{15}$, $Q_{14}$) connectés en série l'un à l'autre et ayant leurs grilles connectées respectivement à la borne de sortie et à la borne d'entrée, le condensateur ($C_A$) étant branché entre le point de jonction commun des second et troisième transistors à effet de champ à canal P ($Q_{16}$, $Q_{15}$) et la borne de masse, et caractérisé en outre en ce qu'il comprend un second circuit auxiliaire comportant un cinquième transistor à effet de champ à canal P ($Q_{13}$) connecté entre la borne (16) de l'alimentation et la borne de sortie (17) et ayant sa grille branchée via un circuit à retard (14) à la borne d'entrée (15).

6. Circuit de commande selon la revendication 5, caractérisé en ce que le second circuit auxiliaire comprend un sixième transistor à effet de champ à canal P ($Q_{17}$) inséré entre le cinquième transistor à effet de champ à canal P ($Q_{13}$) et la borne de sortie (17) et ayant sa grille connectée à la borne d'entrée (15).

0 086 090

FIG.1

FIG.2

1

FIG.3

FIG.4

FIG.6

FIG.5